# EUROPEAN PATENT APPLICATION

(11) **EP 2 211 193 A1**
(43) Date of publication of application: **28.07.2010**
(21) Application number: 10151560.9
(22) Date of filing: 25.01.2010
(51) Int. Cl.: G01R 31/36, B60L 11/18, H01M 10/48, H02J 7/00

(54) **Method and equipment for monitoring and controlling the operating state of the individual cells of an electric accumulator**

(30) Priority: 26.01.2009 IT BO20090034
(71) Applicant: EFI Technology S.r.l., 40012 Lippo di Calderara di Reno (IT)
(72) Inventor: Campi, Piero, I-41051 CASTELNUOVO RANGONE, Province o (IT)
(74) Representative: Porsia, Dino

(57) **Abstract**

Each cell (1, 1' and 1 n) of an accumulator (3) is provided with a peripheral electronic control unit (CCU, 4) which is connected to sensors of temperature, voltage and/or other operating parameters of each individual cell and/or is connected to means for controlling the charging or discharging phase of the cell, and this peripheral control unit is designed to be connected to a small data reception and transmission (Rx/Tx) unit (6), operating for example at radio frequency or by means of another wireless system. The accumulator is provided with at least one central electronic control unit (BMS, 8) which can be connected by means of a CPU (9) and its own Rx/Tx unit (7) to the corresponding Rx/Tx units (6) of the individual cells in order to receive from these the data on the operation of the cells, for the purpose of comparing these with programmed safety data and automatically interrupting the operation of the accumulator if the operating data obtained from one or more cells differ from preset and programmed values, and/or for the purpose of transmitting regulating and balancing commands to the cells in order to prolong the correct and safe operation of the electric accumulator (3).

## Description

The invention relates to electric accumulators in general, and more specifically to those of the new generation, for example those of the lithium polymer or other type, which have greatly reduced overall dimensions while still providing the same performance as electric accumulators of the previous generation, as a result of which these accumulators are increasingly used in the fields of telephony, computer hardware, hobbies, and means of locomotion using fully electric or hybrid traction.

The new generation of electric accumulators also use cells which individually supply low voltages, and therefore a plurality of cells have to be connected in series with each other in order to reach the voltages required for the application for which the accumulators are intended. Even if strict production standards are maintained, the operating characteristics of the cells of an accumulator of the new generation differ from each other, and their behaviour in the charging or discharging phase can change over time and can be degraded to such an extent that the operation of the whole set of cells forming the accumulator is compromised. Since these accumulators are still very costly, and since the aforesaid operating anomalies can also give rise to safety problems for users, the aim of the prior art has been to control the operating characteristics of the individual cells of an accumulator, by providing voltage and temperature sensors for each cell and connecting these sensors with electrical wiring to a central control unit which is designed to control and if necessary balance the operation of the individual cells in the charging and discharging phases, in order to keep the operation of the accumulator unchanged and safe over time, or in order to switch off the accumulator temporarily if serious problems arise.

If storage units formed by a large number of accumulators of the type in question, connected in series, or in series and in parallel, with each other, are used, as in the case of automotive applications, then the aforesaid wiring for connecting the individual cells to the central control unit and/or for interconnecting a plurality of these units would be difficult to design, would create numerous problems in operation and would introduce problems of bulk which would counteract most of the benefits offered by the limited overall dimensions of the new accumulators.

The invention is intended to overcome these and other drawbacks of the known art with the solution described in the appended Claim 1 and in the subsequent dependent claims, based on the following proposed solution. Each cell of an accumulator is provided with a peripheral electronic control unit, which is connected to sensors of temperature, voltage and/or other operating parameters of each individual cell, and/or is connected to means for controlling the charging or discharging phase of the cell, and this peripheral control unit is designed to be connected to a small data reception and transmission (Rx/Tx) unit, operating for example at radio frequency or by means of another wireless system. The accumulator is provided with at least one central electronic control unit which can be connected through a CPU and its own Rx/Tx unit to the corresponding Rx/Tx units of the individual cells in order to receive from these the data on the operation of the cells, for the purpose of comparing these with programmed safety data and automatically interrupting the operation of the accumulator if the operating data obtained from one or more cells differ from preset and programmed values, and/or for the purpose of transmitting regulating and balancing commands to the cells, the whole arrangement dispensing with the need for electrical wiring and being free of the difficulties encountered in the prior art.

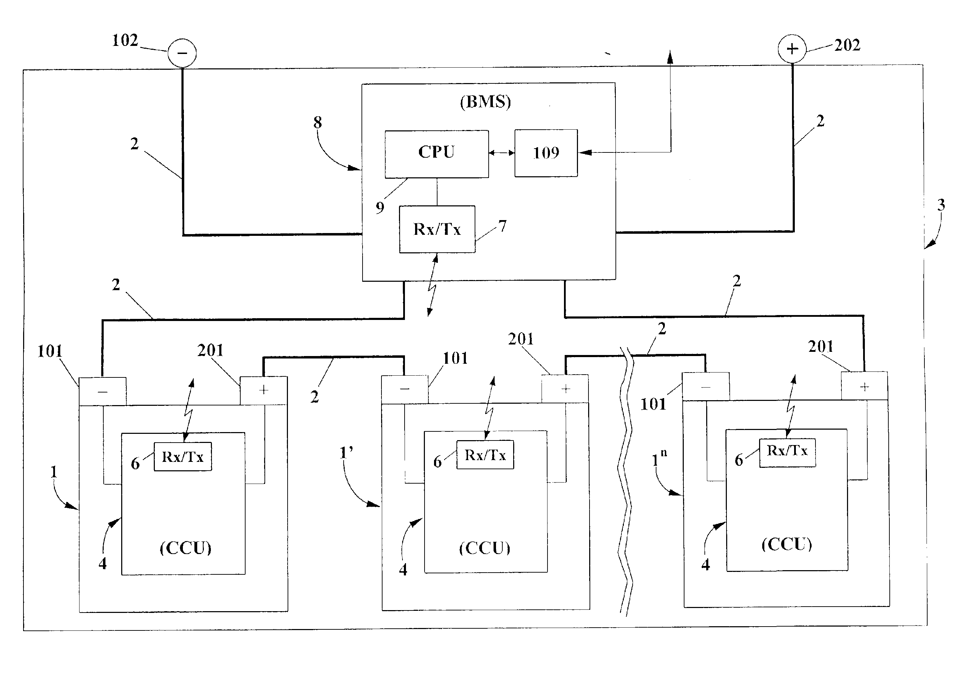

Further characteristics of the invention, and the advantages resulting therefrom, will be made clearer by the following description of a possible embodiment of the invention, illustrated purely by way of non-limiting example in the attached sheet of drawing, in which the single figure shows a block diagram of an embodiment of the invention.

In the drawing, the numerals 1, 1' and 1n indicate the cells forming an electric accumulator 3, the negative poles 101 and positive poles 201 of these cells being connected in series with each other by means of the circuit 2 terminating on the negative terminal 102 and the positive terminal 202 of the accumulator 3. Each cell of the accumulator is provided with a peripheral electronic unit 4 for controlling the cell, also referred to below by the abbreviation CCU (Cell Control Unit), this unit being provided with means for detecting the voltage at the poles 101 and 201, the temperature at one significant point of the cell at least, and any other operating characteristics or parameters of the cell as necessary, and also being provided if necessary with means for controlling the charging or discharging phase of the cell. The CCU 4 is designed for operational connection to a unit 6 which has at least transmitting functions, but which preferably has both transmitting and receiving functions, and which operates, for example, at radio frequency or by means of another known remote receiving and transmitting system in which no electrical wiring is necessary, in other words any wireless system. The peripheral components 4 and 6 can be made mainly in the form of integrated circuits, with very small overall dimensions, and can easily be fitted into each cell of the accumulator during the production of the cell.

The receiving and transmitting units 6 of the cells 1, 1' and 1n of the accumulator 3 are designed to interact with the unit 7, which is at least a receiving unit but is preferably both a receiving and a transmitting unit, of a central electronic unit 8, also referred to below by the abbreviation BMS (Battery Management System), connected to the main circuit 2 of the accumulator, in such a way that it receives from the latter the voltage across the terminals 102, 202 and also, if necessary, the level of the current flowing in the accumulator. A CPU 9 with appropriate software interconnects the units 7 and 8, and is provided with a communication line 109 leading to external means (see below).

Because of the connection of the receiving and transmitting unit 7 to the individual receiving and transmitting units 6 of the peripheral units 4 of the cells 1, 1' and 1n which make up the accumulator 3, the central BMS unit 8 is able to determine the various operating parameters of the cells and compare them with programmed parameters, and can automatically provide selective control of their operation during the charging or discharging phases, for example by means of hard-wired or programmable CPUs (not shown) of the peripheral units 4, or can automatically interrupt the supply of current from the accumulator 3 if anomalous operating conditions are detected in one or more cells which might compromise the safe operation of the accumulator. It is possible to interrogate or program the CPU 9 via the communication line 109. It is also possible to use the same line 109 and an easily produced external electronic unit (not shown) to control the operation of a plurality of electric accumulators which are combined in any suitable way to form a single storage unit. If a unit of this kind is to be formed from a considerable number of electric accumulators, the communication line 109 can be replaced by a receiving and transmitting unit, the whole arrangement being evident to, and easily produced by, persons skilled in the art.

It should be understood that the description omits the details of construction of the Rx/Tx units 6 and 7, the peripheral CCU units 4 and the central BMS unit 8, since the whole arrangement can easily be produced by persons skilled in the art on the basis of the stated aims.

## Claims

1. Equipment for monitoring and controlling the operating state of the individual cells (1, 1' and 1 n) of an electric accumulator (3), comprising:
- a peripheral monitoring and control unit (CCU, 4) which is connected to sensors of temperature, voltage and/or other operating parameters of each cell (1, 1' and 1n) and which is provided with means for connection to corresponding means of a central electronic unit (BMS, 8), which controls the operation of the accumulator (3) and which is provided with means for detecting the voltage at the terminals of the accumulator and if necessary also the charging and/or discharging current of the accumulator;
- in which the operational connection between said means of said peripheral units (CCU, 4) and said central unit (BMS, 8) is made by means of corresponding units which are at least transmitting units (6) and at least receiving units (7), operating for example at radio frequency or by means of another wireless system, the whole arrangement being such that the central electronic unit (BMS, 8) can receive the data on the operation of the individual cells in order to compare them with programmed values and in order to determine at least whether it is necessary to switch off the accumulator automatically and safely if said data on the operation of one or more cells is degraded to levels such that the repeated safe operation of the accumulator is compromised.

2. Equipment according to Claim 1, in which said transmitting (6) and receiving (7) units of the peripheral units (CCU, 4) and of the central unit (BMS, 8) are all combined receiving and transmitting (Rx/Tx) units.

3. Equipment according to Claim 2, in which the peripheral units (CCU, 4) of each cell (1, 1' and 1n) can be provided with corresponding hard-wired or programmable CPUs.

4. Equipment according to Claim 2, in which the peripheral units (CCU, 4) of each cell (1, 1', 1n) can also be provided with means for controlling the charging or discharging phase of the cell, such as balancing means, and the central unit (BMS, 8) can be provided with means for selectively transmitting the regulating commands for the charging or discharging phases to the peripheral units (CCU, 4) of the cells.

5. Equipment according to Claim 1, in which said central unit (BMS, 8) is provided with an external communication line (109) for all control and programming requirements and for the safe control, if required, of the operation of a plurality of electric accumulators combined in any suitable way to form a single storage unit.

6. Equipment according to Claim 5, in which said external communication line (109) can be of the electric wire type or of the wireless type.

7. Method for monitoring and controlling the operating state of the individual cells (1, 1' and 1 n) of an electric accumulator (3), comprising:
- steps of detecting the data on the operation of each cell (1, 1' and 1 n), such as the data relating to the voltage and temperature, and steps of processing these data for transmission over a distance, using any wireless system;
- a step of receiving the data on the operation of each cell of the accumulator (3) and steps of processing these data and comparing them with programmed data, and a step of automatic interruption of the operation of the accumulator if the data on the operation of each cell are degraded to levels such that the correct and safe operation of the accumulator over time is compromised.

8. Method according to Claim 7, **characterized in that** it also comprises steps of selectively regulating the operation of each cell in the charging or discharging phase and a step of establishing this selective regulation if conditions of incorrect operation of a cell are detected, in order to balance the operation of the various cells and avoid any deviations which might cause the automatic interruption of the operation of the accumulator.
